**Europäisches Patentamt**

**European Patent Office**

**Office européen des brevets**

(11) Veröffentlichungsnummer: **0 036 086**

**A1**

## (12) EUROPÄISCHE PATENTANMELDUNG

(21) Anmeldenummer: **81101104.8**

(22) Anmeldetag: **17.02.81**

(51) Int. Cl.³: **H 03 J 7/18**

(30) Priorität: **14.03.80 DE 3009787**

(43) Veröffentlichungstag der Anmeldung:
**23.09.81 Patentblatt 81/38**

(84) Benannte Vertragsstaaten:
**DE FR GB IT NL**

(71) Anmelder: **Deutsche ITT Industries GmbH**
**Hans-Bunte-Strasse 19 Postfach 840**
**D-7800 Freiburg(DE)**

(84) Benannte Vertragsstaaten:
**DE**

(71) Anmelder: **ITT INDUSTRIES, INC.**
**320 Park Avenue**
**New York, NY 10022(US)**

(84) Benannte Vertragsstaaten:
**FR GB IT NL**

(72) Erfinder: **Miskin, Leslie**
**Industriestrasse 2A**
**D-7803 Gundelfingen(DE)**

(74) Vertreter: **Stutzer, Gerhard, Dr.**
**Deutsche ITT Industries GmbH Patent- und**
**Lizenzabteilung Hans-Bunte-Strasse 19 Postfach 840**
**D-7800 Freiburg(DE)**

(54) **UKW-Autoradio mit zwei Empfangsteilen und mit zwei Sendersuchlaufeinrichtungen.**

(57) Zur Bedienungsvereinfachung ist beim vorliegenden UKW-Radio das erste Empfangsteil (11) auf einen Sender eingestellt und zugleich arbeitet die Sendersuchlaufeinrichtung (22) des zweiten Empfangsteils (21) und umgekehrt. Eine Korrelationsanordnung (3) vergleicht die von den Empfangsteilen (11, 21) gelieferten NF-Signale (NF1, NF2) auf gleichen Informationsinhalt, und ein Amplitudenvergleicher (4) ermittelt, welches der von den Empfangsteilen (11, 21) gelieferten ZF-Signale (ZF1, ZF2) die größere Amplitude hat, oder ein Rauschabstandsvergleicher ermittelt, welches der ZF-Signale (ZF1, ZF2) den größeren Rauschabstand hat. Bei festgestellter Gleichheit der NF-Signale (NF1, NF2) wird der Suchlaufvorgang im gerade suchenden Empfangsteil gestoppt, und das mit der größeren Amplitude bzw. dem größeren Rauschabstand wird über einen elektronischen Umschalter (71, 72, 73) an den Eingang des NF-Signalkanals (5, 6) gelegt, und im Empfangsteil mit der kleineren Amplitude bzw. dem kleineren Rauschabstand wird der Suchlaufvorgang wieder ausgelöst. Bei einer von Hand vorgenommenen Einstellungsänderung am ersten Empfangsteil (11) wird der NF-Signalkanal (5, 6) zweckmäßig über den elektronischen Umschalter (71, 72, 73) an das erste Empfangsteil (11) gelegt. Der Amplitudenvergleicher (4) stellt sich zweckmäßig reziprok zum Empfindlichkeitsunterschied der Empfangsteile (11, 21) ein.

./...

EP 0 036 086 A1

0036086

L. Miskin-16

Fl 1035 EP
Mo/bk
10. Februar 1981

UKW-Autoradio mit zwei Empfangsteilen und mit zwei Sendersuchlaufeinrichtungen

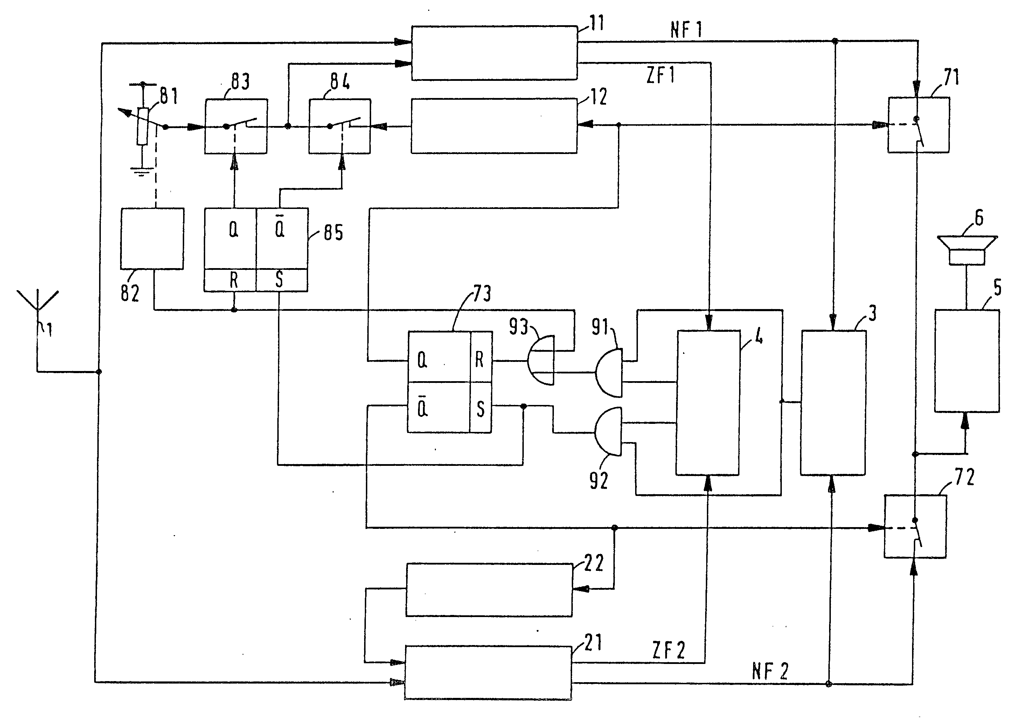

Die Erfindung betrifft UKW-Autoradios mit zwei Empfangsteilen (Tuner, Oszillator, Mischstufe, ZF-Verstärker,
Begrenzer, FM-Demodulator), von denen das erste kontinuierlich oder über Stationstasten von Hand abstimmbar ist
und von denen beide eine selbsttätige Sendersuchlaufeinrichtung enthalten, und mit lediglich einem restlichen
NF-Signalkanal, vgl. den Oberbegriff des Anspruchs 1.
Derartige UKW-Autoradios sind in der Zeitschrift "Funkschau", 1974, Seiten 535 bis 538, insbesondere Bild 6 auf
Seite 538 im Zusammenhang mit Verkehrsfunkdecodern beschrieben. Die Lösung mit zwei Empfangsteilen und getrennter Sendersuchlaufeinrichtung für den Verkehrsfunk-
Decoderteil wird dort als aufwendigste Lösung eines derartigen UKW-Autoradios bezeichnet.

In der Zeitschrift "Funktechnik", 1979, Seiten T475 und
T476 ist andererseits ein microcomputergesteuertes Autoradio beschrieben, das sich selbsttätig auf den stärksten
Programmsender einstellt. Hierzu ist es erforderlich, daß
bis zu 10 verschiedene UKW-Sender gleichen Programms, also
beispielsweise die auf den Sendebereich verteilten UKW-
Sender einer bestimmten Runkfunkanstalt, z.B.Südwestfunk,
zweites Programm, vom Benutzer eingespeichert werden. Der
Microcomputer sucht dann stets den Sender aus diesen gespeicherten heraus,dessen Signal am stärksten einfällt.

Die Erfindung geht von diesen beiden bekannten Anordnungen
aus und hat sich zur Aufgabe gestellt, ein UKW-Autoradio
anzugeben, das ebenfalls den stärksten Programmsender

0036086

L.Miskin-16                                    Fl 1035 EP

selbsttätig einstellt, bei dem darüberhinaus jedoch die vom Benutzer vorzunehmende Eingabe der Sender gleichen Programms in einem bestimmten Sendebereich nicht erforderlich ist und das ohne Microcomputersteuerung realisierbar ist. Diese Aufgabe wird mit den im Kennzeichen des Anspruchs 1 angegebenen Mitteln gelöst.

Die Erfindung kann auf die vom Benutzer vorzunehmende Eingabe der Sender gleichen Programms wegen der erfindungsgemäß vorgesehenen Korrelationsanordnung zum Vergleich des Informationsinhalts der von den beiden Empfangsteilen gelieferten NF-Signale verzichten. Außerdem ist zur Steuerung kein Microcomputer erforderlich, sondern es werden wenige Impulsschaltungen und logische Glieder benötigt.

Die Erfindung wird nun anhand der Figur der Zeichnung näher erläutert, die das Blockschaltbild eines bevorzugten Ausführungsbeispiels zeigt. Über die Antenne 1 gelangt das UKW-Signal zu den beiden Empfangsteilen 11, 21, die in üblicher Weise jeweils aus Tuner, Oszillator, Mischstufe, ZF-Verstärker, Begrenzer und FM-Demodulator bestehen. Jedem Empfangsteil 11, 21 ist eine Sendersuchlaufeinrichtung 12, 22 zugeordnet. Die Handabstimmvorrichtung 81, die in der Figur als Abstimmpotentiometer zur Einstellung einer Abstimmspannung für in den Empfangsteilen 11, 21 vorhandene Kapazitätsdioden gezeigt ist, wirkt über den elektronischen Ruhekontakt 83 auf den Tuner des Empfangsteils 11 und auf die Sensorschaltung 82 ein, die eine Veränderung der Abstimmspannung mittels der Handabstimmvorrichtung 81 oder auch lediglich deren Berühren zu einem Impuls verarbeitet, der dem R-Eingang des RS-Flipflops 85 zugeführt ist. Der zum R-Eingang gehörende Q-Ausgang des RS-Flipflops 85 steuert den elektronischen

L.Miskin-16                                           Fl 1035 EP

Ruhekontakt 83.

Für die Funktionsweise ist die sogenannte positive Logik vorausgesetzt, bei der einer binären Eins der positivere zweier Binärpegel zugeordnet ist. "Q-Ausgang" bedeutet, daß die binäre Eins abgegeben wird, wenn am S-Eingang eine binäre Eins ansteht. Mit "Ruhekontakt" ist ein elektronischer Schalter gemeint, der bei einer binären Eins an seinem Steuereingang geöffnet wird, mit "Arbeitskontakt" dagegen ein elektronischer Schalter, der bei einer Eins an seinem Steuereingang geschlossen wird.

Eins-
Wenn der von der Sensorschaltung 82 erzeugte Impuls also an den R-Eingang des RS-Flipflops 85 abgegeben wird, wird der elektronische Ruhekontakt 83 wegen der am Q-Ausgang liegenden Null geschlossen. Gleichzeitig wird der elektronische Ruhekontakt 84 wegen der am $\bar{Q}$- Ausgang liegenden Eins geöffnet. Bei Handbetätigung gelangt also nicht die von der ersten Sendersuchlaufeinrichtung 12 erzeugte Abstimmspannung, sondern die von der Handabstimmung 81 erzeugte Abstimmspannung zum Tuner der ersten Empfangseinrichtung 11. Mit der von der Sensorschaltung 82 erzeugten Eins wird auch über das ODER-Glied 93 der R-Eingang des RS-Flipflops 73 angesteuert, dessen Q-Ausgang den elektronischen Ruhekontakt 71 mit einer Null ansteuert und diesen, der zuvor geöffnet war, nunmehr schließt. Gleichzeitig wird über den $\bar{Q}$- Ausgang des RS-Flipflops 73 der elektronische Ruhekontakt 72 mit einer Eins angesteuert und somit geöffnet. Daher übernimmt während einer Handabstimmung das erste Empfangsteil 11 die Ansteuerung des NF-Signalkanals, der aus dem NF-Verstärker 5 und dem Lautsprecher 6 besteht. Der Eingang des NF-Verstärkers 5 ist sowohl mit dem Ausgang des elektronischen Ruhekontakts 71 als auch mit dem des elektronischen     Ruhekontaktes 72 verbunden.

Gleichzeitig mit der Umschaltung der beiden elektronischen
Kontakte 71, 72 stoppt das RS-Flipflop 73 auch den Suchlaufvorgang der ersten Sendersuchlaufeinrichtung 12, da
dessen Q-Ausgang mit deren Freigabeeingang verbunden ist,
an dem eine Null anliegt. Andererseits wird über den
$\overline{Q}$-Ausgang des RS-Flipflops 73 die zweite Sendersuchlaufeinrichtung 22 freigegeben, da dieser $\overline{Q}$-Ausgang ebenfalls
mit deren Freigabeeingang verbunden ist und dort eine Eins
anliegt. Somit ist sichergestellt, daß während einer Handabstimmung nur das zweite Empfangsteil 21 in Suchlaufbetrieb
arbeitet.

Die eben beschriebenen Funktionsabläufe bei Vornahme einer
Handabstimmung stellen an sich nur einen Sonderfall dar,
während die "Normal"-Funktion des erfindungsgemäßen UKW-
Autoradios nunmehr beschrieben werden soll. Es ist daran zu
erinnern, daß bei nichtbetätigter Handabstimmung 81 die
Suchlaufeinrichtung 12 über den geschlossenen elektronischen
Ruhekontakt 84 mit dem Tuner des ersten Empfangsteils 11
zusammenarbeitet. Das NF-Signal NF1 des ersten Empfangsteils 11
ist außer dem elektronischen Ruhekontakt 71 auch dem einen
Eingang der Korrelationsanordnung 3 zugeführt, an deren anderem
Eingang das NF-Signal NF2 des zweiten Empfangsteils 12 liegt.
Die Korrelationsanordnung 3 gibt bei Übereinstimmung des
Informationinhalts der beiden NF-Signale NF1, NF2 ein Einsimpuls an jeweils einen Eingang der UND-Glieder 91, 92 ab.

Das ZF-Signal ZF1 des ersten Empfangsteils 11 ist dem einen
Eingang des Amplitudenvergleichers 4 zugeführt, an dessen
anderem Eingang das ZF-Signal ZF2 des zweiten Empfangsteils 21
liegt. Der dem ZF-Signal ZF1 zugeordnete Ausgang ist mit
dem zweiten Eingang des UND-Glieds 91 und der dem ZF-Signal
ZF2 zugeordnete Ausgang mit dem zweiten Eingang des UND-
Glieds 92 verbunden. Diese beiden Ausgänge geben jeweils eine Eins ab, wenn das eine ZF-Signal eine größere Amplitude als das andere hat.

Somit wird bei festgestellter Gleichheit des Informationsinhalts der NF-Signale NF1, NF2 entweder der R-Eingang des RS-Flipflops 73 (ZF-Signal ZF1 hat größere Amplitude) oder dessen S-Eingang (ZF-Signal ZF2 hat größere Amplitude) mit einer Eins angesteuert. Ermittelt somit beispielsweise der Amplitudenvergleicher 4 eine größere Amplitude in der zweiten Empfangseinrichtung 21, so gelangt die am zugeordneten Ausgang liegende Eins über das UND-Glied 92 zum S-Eingang des RS-Flipflops 73 und ebenso zum S-Eingang des RS-Flipflops 85. Über den $\overline{Q}$-Ausgang des RS-Flipflops 73 gelangt somit eine Null an den Freigabeeingang der zweiten Sendersuchlaufeinrichtung 22, wodurch der Suchlaufvorgang gestoppt wird. Gleichzeitig wird mittels dieser Null der elektronische Ruhekontakt 72 auch geschlossen, so daß der NF-Verstärker 5 und der Lautsprecher 6 von der zweiten Empfangseinrichtung 21 angesteuert werden.

Die Eins am Ausgang des UND-Glieds 92 liegt, wie bereits erwähnt, auch am S-Eingang des RS-Flipflops 85, wodurch mit der Eins an dessen Q-Ausgang der elektronische Ruhekontakt 83 geöffnet und mit der Null am $\overline{Q}$-Ausgang der elektronische Ruhekontakt 84 geschlossen wird, so daß nunmehr das erste Empfangsteil 11 von der ersten Sendersuchlaufeinrichtung 12, die über die Eins am Q-Ausgang des RS-Flipflops 73 freigegeben ist, eine Abstimmspannung zugeführt erhält. Durch die letzterwähnte Eins am Q-Ausgang des RS-Flipflops 73 ist auch der elektronische Ruhekontakt 71 geöffnet, was hiermit nachgetragen sei.

Ermittelt die Korrelationsanordnung 3 einen Sender, dessen Informationsinhalt dem des NF-Signals NF2 entspricht und stellt daraufhin der Amplitudenvergleicher 4 eine größere

**0036086**

L.Miskin-16                                          Fl 1035 EP

Signalstärke im ersten Empfangsteil 11 fest, so wird über die dann zum R-Eingang des RS-Flipflops 73 gelangende Eins, wie oben bereits beschrieben, dieses Empfangsteil zum NF-Verstärker 5 und Lautsprecher 6 durchgeschaltet.

Das UKW-Autoradio nach der Erfindung sucht somit selbsttätig den stärksten Sender eines Bereichs.

Anstatt des Amplitudenvergleichers 4 kann auch ein Rauschabstandsvergleicher verwendet werden. Ferner ist es vorteilhaft, wenn sich der Amplitudenvergleicher 4 reziprok zum Empfindlichkeitsunterschied der beiden Empfangsteile 11, 21 einstellt.

L.Miskin-16

Fl 1035 EP
Mo/bk


Patentansprüche


1. UKW-Autoradio mit zwei Empfangsteilen (Tuner, Oszillator, Mischstufe, ZF-Verstärker, Begrenzer, FM-Demodulator)(11,21) von denen das erste kontinuierlich oder über Stationstasten von Hand abstimmbar ist und von denen beide eine selbsttätige Sendersuchlaufeinrichtung (12,22) enthalten, und mit lediglich einem restlichen NF-Signalkanal (5,6), gekennzeichnet durch folgende Merkmale:
   - während das erste Empfangsteil (11) auf einen Sender eingestellt ist, arbeitet die Sendersuchlaufeinrichtung (22) des zweiten Empfangsteils (21) und umgekehrt,
   - eine Korrelationsanordnung (3) vergleicht die von den beiden Empfangsteilen (11, 21) gelieferten NF-Signale (NF1, NF2) auf gleichen Informationsinhalt,
   - ein Amplitudenvergleicher (4) ermittelt, welches der von den beiden Empfangsteilen (11, 21) gelieferten ZF-Signale (ZF1, ZF2) die größere Amplitude hat, oder
   - ein Rauschabstandsvergleicher ermittelt, welches der von den beiden Empfangsteilen (11, 21) gelieferten ZF-Signale (ZF1, ZF2) den größeren Rauschabstand hat,
   - bei festgestellter Gleichheit der NF-Signale (NF1, NF2) wird der Suchlaufvorgang im gerade suchenden Empfangsteil gestoppt, und das Empfangsteil mit der größeren Amplitude bzw. dem größeren Rauschabstand wird über einen elektronischen Umschalter (71, 72, 73 ) an den Eingang des NF-Signalkanals (5, 6) gelegt, und
   - im Empfangsteil mit der kleineren Amplitude bzw. dem kleineren Rauschabstand wird der Suchlaufvorgang wieder ausgelöst.

L.Miskin-16                                      Fl 1035   EP

2. Autoradio nach Anspruch 1, dadurch gekennzeichnet, daß bei einer von Hand vorgenommenen Einstellungsänderung am ersten Empfangsteil (11) der NF-Signalkanal (5, 6) über den elektronischen Umschalter (71, 72, 73) an das erste Empfangsteil (11) gelegt ist.

3. Autoradio nach Anspruch 1 oder 2, dadurch gekennzeichnet, daß sich der Amplitudenvergleicher (4) reziprok zum Empfindlichkeitsunterschied der beiden Empfangsteile (11, 21) einstellt.

NF 1

ZF 1

ZF 2

NF 2

1/1

0036086

Europäisches
Patentamt

**EUROPÄISCHER RECHERCHENBERICHT**

**0036086**
Nummer der Anmeldung

EP 81101104.8

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | <u>DE - A1 - 2 724 068</u> (PAGE)<br><br>+ Fig.; Seite 4, Zeile 8 - Seite 5, Zeile 27 +<br><br>-- | 1,2 |
|  | <u>DE - A - 1 591 144</u> (GOTTSTEIN)<br><br>+ Fig. 1; Seite 5, Zeile 26 - Seite 7, Zeile 15 +<br><br>-- | 1 |
|  | <u>US - A - 4 063 179</u> (BROWN)<br><br>+ Fig. 1; Spalte 4, Zeilen 1-61 +<br><br>-- | 1 |
| A,D | FUNKSCHAU, Heft 14, 1974, Franzis-Verlag, München<br><br>JOACHIM CONRAD "Grünes Licht für den Verkehrsfunk", Seiten 535-538<br><br>+ Bild 6c; Seite 538, mittlere Spalte, Zeilen 31-43 +<br><br>---- | 1 |

**KLASSIFIKATION DER ANMELDUNG (Int. Cl.³)**

H 03 J 7/18

**RECHERCHIERTE SACHGEBIETE (Int. Cl.³)**

H 03 J 7/00

H 04 N 5/00

H 04 H 1/00

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 15-06-1981 | DRÖSCHER |

EPA form 1503.1   06.78